Europäisches Patentamt

European Patent Office

Office européen des brevets

(19)

(11) Veröffentlichungsnummer: **0 224 005**
**B1**

(12) **EUROPÄISCHE PATENTSCHRIFT**

(45) Veröffentlichungstag der Patentschrift:
03.01.90

(51) Int. Cl.⁴: **G01N 24/08**

(21) Anmeldenummer: 86114268.5

(22) Anmeldetag: 15.10.86

(54) Kernspinresonanzgerät für die schnelle Bestimmung der Längsrelaxationszeit T1.

(30) Priorität: 29.10.85 DE 3538464

(43) Veröffentlichungstag der Anmeldung:
03.06.87 Patentblatt 87/23

(45) Bekanntmachung des Hinweises auf die Patenterteilung:
03.01.90 Patentblatt 90/1

(84) Benannte Vertragsstaaten:
DE FR GB NL

(56) Entgegenhaltungen:
EP-A- 0 135 847
EP-A- 0 205 223
US-A- 137 420
US-A- 4 383 219

E. FUKUSHIMA et al.: "Experimental Pulse NMR", 1981, Seiten 164-196, Addison-Wesley Publishing Company, Inc., Massachusetts, US; "III. D. Measurement of spin-lattice relaxation"
SCIENTIFIC AMERICAN, Band 246, Nr. 5, Mai 1982, Seiten 54-64, New York, US; I.L. PYKETT: "NMR imaging in medicine"
JOURNAL OF PHYSICS-E: SCIENTIFIC INSTRUMENTS, Band 15, Nr. 1, Januar 1982, Seiten 74-79, The Institute of Physics, Dorking, GB; G. JOHNSON et al.: "Instrumentation for NMR spin-warp imaging"

(73) Patentinhaber: Siemens Aktiengesellschaft,
Wittelsbacherplatz 2, D-8000 München 2(DE)

(72) Erfinder: Oppelt, Arnulf, Dr., Schwedenstrasse 25,
D-8521 Spardorf(DE)
Erfinder: Graumann, Rainer, Dr.,
Lucas-Cranach-Strasse 39, D-8552 Höchstadt(DE)

(56) Entgegenhaltungen: (Fortsetzung)
JOURNAL OF COMPUTER ASSISTED TOMOGRAPHY, Band 7, Nr. 3, Juni 1983, Seiten 391-401, Raven Press, New York, US; W.A. EDELSTEIN et al.: "Signal, noise, and contrast in Nuclear Magnetic Resonance (NMR) imaging"
PHYSICS ABSTRACTS, SCIENCES ABSTRACTS SERIE A, Band 80, Nr. 1068, 15. Juli 1977, Seite 3686, Zusammenfassung Nr. 49752, London, GB; J. KRONENBITTER et al.: "A new technique for measuring the relaxation times T1 and T2 and the equilibrium magnetization M0 of slowly relaxing systems with weak NMR signals" 000

## Beschreibung

Die Erfindung betrifft ein Kernspinresonanzgerät mit einem Grundfeldmagneten und einem Hochfrequenzsender, bei dem das Spinsystem eines Untersuchungsobjektes durch Anlegen eines magnetischen Grundfeldes durch den Grundfeldmagneten sowie durch Bestrahlung mit Folgen von Hochfrequenzpulsen durch den Hochfrequenzsender angeregt wird und die vom Spinsystem ausgesandten Kernresonanzsignale gemessen werden.

Messungen der Längsrelaxationszeit $T_1$ wurden bisher meßtechnisch exakt nur in extrem langen Meßzeiten realisiert. Bekannte Verfahren, z.B. das Inversion-Recovery-Verfahren oder das Saturation-Recovery-Verfahren ("Scientific American", Band 246, Nr. 5, Mai 1982, Seiten 54-64) sind zeitlich langwierige Meßverfahren, da sie nach einer Anregung des Spinsystems stets nur einen Punkt der Relaxationskurve $M_Z(t)$ bestimmen (z.B. durch Aufnahmen mit unterschiedlicher Repetitionszeit $T_R$ oder Inversionszeit I).

Andere bekannte Verfahren sind in E. FUKUSHIMA et al.: "Experimental Pulse NHR", 1981, Addison-Wesley Publishing Co. US, Seiten 164–196 und in EP-A 137 420 beschrieben.

Der Erfindung liegt die Aufgabe zugrunde, ein Kernspinresonanzgerätes zu entwickeln, mit dessen Hilfe die Längsrelaxationszeit $T_1$ des zu untersuchenden Spinsystems in wesentlich kürzerer Meßzeit bestimmt werden kann.

Die Aufgabe ist erfindungsgemäß dadurch gelöst, daß die zeitliche Entwicklung des Spinsystems durch Teilauslesepulse, deren zeitlicher Abstand klein im Verhältnis zur Längsrelaxationszeit $T_1$ ist, gemessen wird.

Das Messen eines Punktes der Längsrelaxationskurve $M_Z(t)$ mit Hilfe des bekannten Inversion-Recovery-Verfahrens erzielt man durch folgende Schritte:

Die Magnetisierung des Spinsystems wird in einen fest definierten Anfangszustand gebracht. Man läßt dann das System während einer wählbaren Zeit I (Inversionszeit) relaxieren. Die nach der Zeit I vorhandene Längsmagnetisierung wird durch einmaliges "Kippen" in die X-Y-Ebene mit Hilfe eines 90°-Pulses anhand des sich anschließenden Kernresonanzsignales ausgelesen. Dieser Puls stellt bereits einen so großen Eingriff auf den Magnetisierungszustand dar, daß zur Messung des nächsten Relaxationspunktes das Spinsystem erst wieder in einen genau definierten Startzustand gebracht und erneut die Inversionszeit I abgewartet werden muß.

Im Gegensatz dazu ist bei dem erfindungsgemäßen Gerät nach dem Herstellen der Anfangsmagnetisierung der Eingriff in den Magnetisierungzustand aufgrund der Teilauslesepulse mit kleinem Flipwinkel geringer. Die jeweils herrschende Längsmagnetisierung wird nur zu einem Bruchteil in die X-Y-Ebene gedreht und der Meßvorgang ändert die Längsmagnetisierung deshalb nur geringfügig. Deshalb ist eine wiederholte Erfassung der Relaxationskurve <u>während</u> des Relaxationsvorganges möglich. Dies bedeutet eine erhebliche Zeitersparnis, da nicht jedesmal abgewartet werden muß, bis das Spinsystem in einen definierten Startzustand gelangt.

Die Erfindung ist nachfolgend anhand von Ausführungsbeispielen und der Zeichnung näher erläutert. Es zeigen:

Fig. 1 eine Impulssequenz nach der Erfindung zur schnellen $T_1$-Messung,

Fig. 2 eine Impulssequenz nach der Erfindung zur ortsaufgelösten, schnellen $T_1$-Messung bei der bildgebenden Kernspintomographie, und

Fig. 3 eine Impulssequenz nach der Erfindung zur ortsaufgelösten, schnellen $T_1$-Messung bei inhomogenen Magnetfeldern.

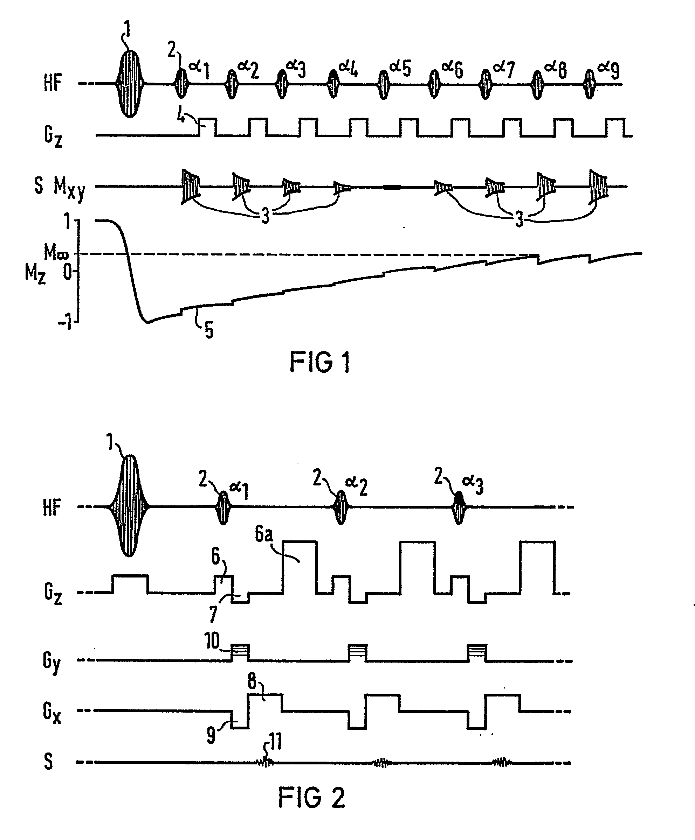

In der Figur 1 ist schematisch der zeitliche Verlauf der von der Hochfrequenz- und Gradienteneinrichtung eines Kernspinresonanzgerätes erzeugten Pulsfolgen bei Anwendung des erfindungsgemäßen Verfahrens dargestellt. Bei diesem Ausführungsbeispiel wird die Magnetisierung des Spinsystems zunächst durch einen Hochfrequenzpuls 1 invertiert. Hierzu kann ein 180°-Puls, das "adiabatic fast passage"-Verfahren oder auch ein speziell von Silver ("Selective Population Inversion in NMR", Nature 310, Seiten 681 bis 683, Aug. 1984) beschriebener selektiver Hochfrequenzpuls benutzt werden. Sodann gelangt eine Anzahl (typischerweise 8 bis 64) Hochfrequenzpulse 2 mit Flipwinkel kleiner als 90° (im folgenden Teilauslesepulse genannt) zur Anwendung. Nach jedem Teilauslesepuls 2 wird das hierdurch angeregte Kernresonanzsignal 3 ausgelesen und anschließend die verbleibende Quermagnetisierung durch einen z-Gradienten-Spoilerpuls 4 zerstört.

Die Teilauslesepulse 2 besitzen Flipwinkel $\alpha_1$, die typischerweise zwischen 5° und 20° liegen. Der Abstand der Teilauslesepulse wird entsprechend dem Verhältnis der zu erwartenden Längsrelaxationszeit zur Anzahl der HF-Pulse eingestellt.

Eine Inversion der Kernmagnetisierung durch den Inversionspuls 1 ist allgemein nicht erforderlich. In Frage kommt als Startmagnetisierung auch Sättigung, d.h. fehlende Quermagnetisierung, oder die thermische Gleichgewichtsmagnetisierung im Magnetfeld vor Applikation der Teilauslesepulse. Bezeichnet man den Bruchteil dieses Startwertes an der Gesamtmagnetisierung des zu vermessenden Kernensembles mit $M_0$ (bei vollständiger Inversion ist also $M_0 = -1$), erfolgen die Teilauslesepulse äquidistant im

zeitlichen Abstand $\Delta t$ und kippen sie die Kernmagnetisierung um den Flipwinkel $\alpha$, ergibt sich die <u>Längsmagnetisierung</u> zum Zeitpunkt $t_n = n \cdot \Delta t$ unmittelbar vor dem n. Teilauslesepuls als Bruchteil $M_n$ an der Gesamtmagnetisierung zu

$$M_n = 1 + \frac{1 - \cos \alpha}{\cos \alpha \, e^{-\Delta t/T_1} - 1} \, e^{-\frac{\Delta t}{T_1}} - \cos^{n-1} \alpha \cdot F$$

wobei

$$F = \left\{ 1 + \frac{1 - \cos \alpha}{\cos \alpha \, e^{-\Delta t/T_1} - 1} - M_0 \cos \alpha \right\} e^{-n \cdot \Delta t/T_1} \qquad [1]$$

Die Längsmagnetisierung strebt somit exponentiell mit der Zeitkonstanten $T_1$, der zu bestimmenden Längsrelaxationszeit, gegen den "steady state"-Wert

$$M_\infty = \frac{1 - e^{-\Delta t/T_1}}{1 - \cos \alpha \, e^{-\Delta t/T_1}}$$

Das nach den Teilauslesepulsen ausgelesene Kernresonanzsignal 3 spiegelt unmittelbar die momentane Längsmagnetisierung $M_n$ wieder:

$S_n = M_n \sin \alpha$

Aus der Gesamtheit aller ausgelesenen Signale 3 läßt sich mittels nachfolgendem mathematischem Anpassungsverfahren die Längsrelaxationszeit $T_1$ ermitteln. Die Gleichung [1] wird durch Umstellen und Logarithmieren in die folgende Form gebracht:

$$\ln (M_n - C_1) = \ln C_2 - \ln \cos \alpha + n \left( \ln \cos \alpha - \frac{\Delta t}{T_1} \right),$$

mit den von n unabhängigen Konstanten $C_1$ und $C_2$

$$C_1 = 1 + \frac{1 - \cos \alpha}{\cos \, e^{-\Delta t/T_1} - 1} \, e^{-\Delta t/T_1}$$

$$C_2 = - \left( 1 + \frac{1 - \cos \alpha}{\cos \alpha \, e^{-\Delta t/T_1} - 1} - M_0 \cos \alpha \right)$$

In einer mathematischen Anpassungsrechnung wird die Konstante $C_1$ als freier Parameter C so lange variiert, bis die Punkte $\ln (M_n - C)$ auf einer Geraden liegen. Aus der daraus bestimmten Geradensteigung m und der Konstanten C läßt sich die Längsrelaxationszeit $T_1$ ohne Kenntnis des Drehwinkels $\alpha$ wie folgt berechnen:

$$T_1 = - \frac{\Delta t}{\ln(C(e^m - 1) + 1)}$$

Um den mit der mathematischen Anpassungsrechnung verbundenen Zeitaufwand zu vermeiden, läßt sich aus dem Nulldurchgang der gemessenen Signale und bei einer ungefähren Kenntnis des Drehwinkels $\alpha$ die Längsrelaxationszeit $T_1$ direkt aus einer vorher mit Hilfe von [1] erstellten Tabelle entnehmen. Dies ermöglicht eine in dieser Schnelligkeit von keinem anderen Verfahren erreichte Bestimmung der Längsrelaxationszeit $T_1$.

Zur Verwendung der vorgeschlagenen schnellen und genauen Methode zur Bestimmung der Längsrelaxationszeit in der bildgebenden Kernspintomographie müssen nach den Teilauslesepulsen geeignete Abbildungsgradienten angelegt und das Kernresonanzsignal ausgelesen werden. Die Methodik hierfür ist an und für sich bekannt.

Die Figur 2 zeigt eine Möglichkeit, das beschriebene Gerät in der Kernspintomographie anzuwenden, wobei die 2d Fourier-Rekonstruktionsmethode benutzt wird.

Zur Schichtauswahl werden die Teilauslesepulse 2 selektiv gemacht, d.h. gleichzeitig ist ein Schichtauswahlgradient $G_z$ 6 eingeschaltet; nach den selektiven Teilauslesepulsen 2 wird die Kernmagnetisierung im umgepolten Schichtauswahlgradienten -$G_z$ 7 rephasiert und danach im Projektionsgradienten $G_x$ 8 ausgelesen. Um den Zeitnullpunkt des ausgelesenen Signales 11 in die Mitte der Auslesezeit zu verlagern, empfiehlt sich eine vorherige Dephasierung der Kernmagnetisierung im umgepolten Projektionsgradienten -$G_x$ 9. Vor der Signalauslesung ist noch ein Kodierungsgradient $G_y$ 10 wirksam. Anschließend folgen Spoilergradienten, um die verbleibende Quermagnetisierung zu zerstören. Hierfür wird z.B. der Schichtauswahlgradient $G_z$ erneut mit solch einer Dauer und Amplitude eingeschaltet, daß das Zeitintegral dieses Gradientenpulses 6a deutlich größer (etwa das Zehnfache) ist als das entspre chende zum Zeitpunkt des Teilauslesepulses 2. Der Gradientenpuls 6a ist deshalb maßstäblich zu klein gezeichnet.

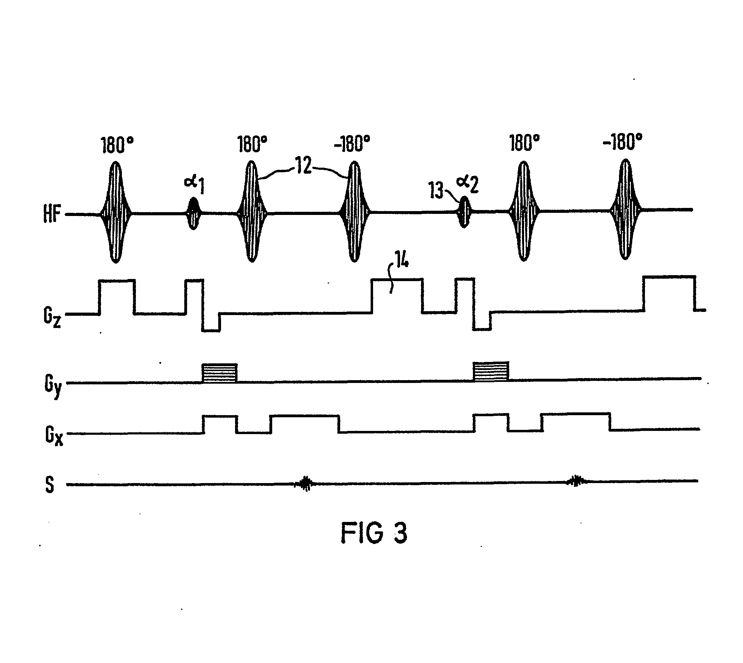

Die Figur 3 zeigt eine Anwendung des erfindungsgemäßen Verfahrens in der Kernspintomographie bei inhomogenen Magnetfeldern. Bei inhomogenen Magnetfeldern ist es vorteilhaft, statt mit den beschriebenen Gradientenechos 11 mit durch ±180°-HF-Pulsen 12 erzeugten Echos zu arbeiten.

Hierbei ist die Pulssequenz so anzulegen, daß die 180°-Pulse stets paarweise und gegenphasig auftreten, so daß keine Sättigung des Kernensembles stattfindet. Die vor Anwendung des nächsten Teilauslesepulses 13 noch vorhandene Quermagnetisierung wird wieder durch einen Gradienten-Spoilerpuls 14 beseitigt.

Auf diese Weise erhält man eine Anzahl n unterschiedlich $T_1$ gewichteter Projektionen. Um hieraus eine gleiche Zahl unterschiedlich $T_1$ gewichteter Bilder berechnen zu können, muß das zur Messung der Projektionen vollzogene Experiment mehrmals (typischerweise 256 mal) mit anderen Projektionsrichtungen bzw. Kodierungen wiederholt werden. Die Erstellung der Gesamtheit der n $T_1$ gewichteten Bilder dauert jedoch nicht länger als die eines Einzelbildes.

Durch Vergleich der Intensität von entsprechenden Bildelementen (Pixeln) aus einer solchen $T_1$ Bildserie läßt sich der Längsrelaxationsvorgang an einem dem Pixel entsprechenden Ort untersuchen - es kann nicht nur die Längsrelaxationszeit genau bestimmt werden - sondern auch analysiert werden, ob etwa mehrere Relaxationszerfälle mit unterschiedlichen Zeitkonstanten vorliegen, z.B. bei "partial volume"-Effekten, wenn etwa Fett und Wasser im gleichen Bildelement vorhanden sind.

**Patentansprüche**

1. Kernspinresonanzgerät mit einem Grundfeldmagneten und einem Hochfrequenzsender, bei dem das Spinsystem eines Untersuchungsobjektes durch Anlegen eines magnetischen Grundfeldes durch den Grundfeldmagneten sowie durch Bestrahlung mit Folgen von Hochfrequenzpulsen durch den Hochfrequenzsender angeregt wird und die vom Spinsystem ausgesandten Kernresonanzsignale gemessen werden, **dadurch gekennzeichnet**, daß die Folge von Hochfrequenzpulsen gebildet wird durch eine Serie von Pulsen mit Flipwinkeln kleiner als 90° (Teilauslesepulse), deren zeitliche Abstände kleiner als die Längsrelaxationszeit des Spinsystems sind, und maximal einem den Teilauslesepulsen vorangestellten Puls, der das Spinsystem in einen vorwählbaren Magnetisierungszustand (Startmagnetisierung) versetzt.

2. Kernspinresonanzgerät nach Anspruch 1, **dadurch gekennzeichnet**, daß die Startmagnetisierung durch einen Inversionspuls mit Flipwinkel 180° auf -$M_z$ gesetzt wird ($M_z$ = thermische Gleichgewichtsmagnetisierung).

3. Kernspinresonanzgerät nach Anspruch 1, **dadurch gekennzeichnet**, daß die Startmagnetisierung durch einen Sättigungspuls zerstört wird.

4. Kernspinresonanzgerät nach einem der Ansprüche 1 bis 3, **dadurch gekennzeichnet**, daß nach jedem Teilauslespuls zur vorzeitigen Löschung der Quermagnetisierung ein Gradienten-Spoilerpuls eingeschaltet wird.

5. Kernspinresonanzgerät nach einem der Ansprüche 1 bis 4, **dadurch gekennzeichnet**, daß aus dem zeitlichen Verlauf der gemessenen Kernresonanzsignale die Längsrelaxationszeit $T_1$ mit Hilfe einer Anpassungsrechnung oder bei einer ungefähren Kenntnis des Drehwinkels $\alpha$ mit Hilfe einer vorher erstellten Wertetabelle bestimmt wird.

6. Kernspinresonanzgerät nach einem der Ansprüche 1 bis 5, **dadurch gekennzeichnet**, daß während der Teilauslesepulse Schichtauswahlgradienten anliegen und während des Auslesens des Kernresonanzsignales Abbildungsgradienten, so daß Projektionen des Meßobjektes mit entsprechend der HF-Pulsposition gewichteter $T_1$-Betonung erhalten werden.

7. Kernspinresonanzgerät nach einem der Ansprüche 1 bis 6, **dadurch gekennzeichnet**, daß zwischen zwei aufeinanderfolgenden Teilauslesepulsen ein 180° Hochfrequenzpuls und ein -180° Hochfrequenzpuls eingefügt sind und Abbildungsgradienten während des Auslesens der Kernresonanzsignale anliegen, so daß Projektionen des Meßobjektes mit entsprechend der HF-Pulsposition gewichteter $T_1$-Betonung erhalten werden und der Einfluß der Feldinhomogenitäten auf die Bildqualität reduziert ist.

8. Kernspinresonanzgerät nach den Ansprüchen 6 und 7, **dadurch gekennzeichnet**, daß aus den Projektionen Bilder entsprechend der Anzahl der Teilauslesepulse rekonstruiert werden, aus denen sich für jeden Bildpunkt die Längsrelaxationszeit berechnen läßt.

**Claims**

1. Nuclear magnetic-resonance apparatus with a basic field magnet and a radio-frequency transmitter, wherein the spin system of an object under investigation is excited by applying a magnetic basic field using the basic field magnet and by irradiation with series of radio-frequency pulses using the radio-frequency transmitter, and the nuclear resonance signals emitted by the spin system are measured, characterised in that the series of radio-frequency pulses is constituted by a series of pulses with flip angles smaller than 90° (partial readout pulses), the intervals between which are smaller than the longitudinal relaxation time of the spin system, and at most one pulse placed in front of the partial readout pulses, which shifts the spin system into a preselectable magnetisation state (starting magnetisation).

2. Nuclear magnetic-resonance apparatus according to claim 1, characterised in that the starting magnetisation is set to −Mz by an inversion pulse with a 180° flip angle (Mz = thermal equilibrium magnetisation).

3. Nuclear magnetic-resonance apparatus according to claim 1, characterised in that the starting magnetisation is destroyed by a saturation pulse.

4. Nuclear magnetic-resonance apparatus according to one of claims 1 to 3, characterised in that after each partial readout pulse a gradient spoiler pulse is introduced for early cancellation of the transverse magnetisation.

5. Nuclear magnetic-resonance apparatus according to one of claims 1 to 4, characterised in that the longitudinal relaxation time $T_1$ is determined from the time characteristic of the measured nuclear resonance signals with the aid of an adjustment computation or with an approximate knowledge of rotation angle $\alpha$ by means of a table of values drawn up previously.

6. Nuclear magnetic-resonance apparatus according to one of claims 1 to 5, characterised in that during the partial readout pulses contour readout gradients are applied and during the reading of the nuclear resonance signal mapping gradients, with the result that projections of the object being measured are obtained with $T_1$ emphasis weighted in accordance with the HF pulse position.

7. Nuclear magnetic-resonance apparatus according to one of claims 1 to 6, characterised in that a 180° radio-frequency pulse and a −180° radio-frequency pulse are interposed between two successive partial readout pulses, and mapping gradients are applied while the nuclear resonance signals are being read, with the result that projections of the object being measured are obtained with $T_1$ emphasis weighted in accordance with the HF pulse position and the influence of the field inhomogeneities on the quality of the image is reduced.

8. Nuclear magnetic-resonance apparatus according to claims 6 and 7, characterised in that images corresponding to the number of partial readout pulses are reconstructed from the projections, from which images the longitudinal relaxation time for each picture element can be computed.

**Revendications**

1. Appareil à résonance magnétique nucléaire comprenant un aimant de champ de base et un émetteur haute fréquence, dans lequel le système de spins d'un objet étudié est excité par application d'un champ magnétique de base par l'aimant de champ de base ainsi que par irradiation avec des successions d'impulsions haute fréquence par l'émetteur haute fréquence, et dans lequel sont mesurés les signaux à résonance magnétique nucléaire émis par le système de spins, caractérisé en ce que la succession d'impulsions haute fréquence est formée par une série d'impulsions avec des angles de basculement inférieurs à 90° (impulsions de lecture partielle) dont les espacements dans le temps sont plus courts que le temps de relaxation longitudinale du système de spins, de même que par tout au plus une impulsion qui précède les impulsions de lecture partielle et qui amène le système de spins à un état de magnétisation pouvant être choisi au préalable (magnétisation de départ).

2. Appareil selon la revendication 1, caractérisé en ce que la magnétisation de départ est établie, par une impulsion d'inversion à angle de basculement de 180°, à −Mz (Mz = aimantation d'équilibre thermique).

3. Appareil selon la revendication 1, caractérisé en ce que la magnétisation de départ est détruite par une impulsion de saturation.

4. Appareil selon une des revendications 1 à 3, caractérisé en ce que, après chaque impulsion de lecture partielle, une impulsion destructrice de gradient est produite pour l'effacement préalable de la magnétisation transversale.

5. Appareil selon une des revendications 1 à 4, caractérisé en ce que le temps de relaxation longitudinale $T_1$ est déterminé à partir de l'allure dans le temps des signaux à résonance magnétique nucléaire mesurés, à l'aide d'un calcul d'adaptation ou, si l'angle de rotation $\alpha$ est à peu près connu, à l'aide d'un tableau de valeurs établi préalablement.

6. Appareil selon une des revendications 1 à 5, caractérisé en ce que des gradients de sélection de couche sont appliqués pendant les impulsions de lecture partielle et des gradients de représentation sont appliqués pendant la lecture du signal à résonance magnétique nucléaire, de manière que l'on obtienne des projections de l'objet étudié avec une accentuation de $T_1$ pondérée conformément à la position de l'impulsion HF.

7. Appareil selon une des revendications 1 à 6, caractérisé en ce qu'une impulsion haute fréquence à 180° et une impulsion haute fréquence à −180° sont insérées entre deux impulsions de lecture partielle successives et des gradients de représentation sont appliqués pendant la lecture des signaux à résonance magnétique nucléaire, de manière que l'on obtienne des projections de l'objet étudié avec une accentuation de $T_1$ pondérée conformément à la position de l'impulsion HF et que l'influence des défauts d'homogénéité du champ sur la qualité de l'image soit réduite.

8. Appareil selon les revendications 6 et 7, caractérisé en ce que des images correspondant au nombre des impulsions de lecture partielle sont reconstruites à partir des projections, images à partir desquelles peut être calculé le temps de relaxation longitudinale pour chaque point d'image.

FIG 1

FIG 2

FIG 3